# EUROPEAN PATENT APPLICATION

(11) **EP 2 284 892 A1**
(43) Date of publication of application: **16.02.2011**
(21) Application number: 09167743.5
(22) Date of filing: 12.08.2009
(51) Int. Cl.: H01L 27/142

(54) **Method of manufacturing a semiconductor device module, semiconductor device connecting device, semiconductor device module manufacturing device, semiconductor device module**

(71) Applicant: Applied Materials, Inc., Santa Clara, CA 95054 (US)
(72) Inventor: Straub, Axel, 55218, Ingelheim (DE)
(74) Representative: Zimmermann, Gerd Heinrich

(57) **Abstract**

A method of forming a semiconductor device module including a number of n semiconductor devices is provided, n being an integer ≥ 2, the method including: providing a substrate (10) coated with a first contact layer (20), having a semiconductor layer (30) formed on the first contact layer, and having a second contact layer (40) formed on the semiconductor layer; and forming a connection of the first contact layer and the second contact layer by forming a number of n-1 conductive paths (50) in a material of the semiconductor layer for connecting the n semiconductor devices.

## Description

### FIELD OF THE INVENTION

Embodiments of the invention relate to semiconductor device modules, for instance to solar cell modules. They relate particularly to a method of manufacturing a semiconductor device module, a semiconductor device connecting device, a semiconductor device module manufacturing device, and a semiconductor device module.

### BACKGROUND OF THE INVENTION

Semiconductor devices have many functions in a plurality of industrial fields, including, but not limited to, fabrication of electronic devices, such as transistors, and photovoltaic cells, such as solar cells. Individual photovoltaic cells are e.g. used for powering small devices such as electronic calculators. Photovoltaic arrays are used for instance in remote area power systems, earth-orbiting satellites and space probes, remote radiotelephones and water pumping applications.

The principle of operation of a solar cell containing a p-n junction can be roughly described as follows. The solar cell absorbs light and generates electron/hole charge pairs due to absorbed light energy. The electrons move toward the n-layer side of the junction, and the holes move toward the p-layer side due to drift caused by the junction electric field and diffusion.

For solar cell production, so called bulk technologies or thin-film technologies may be applied, the former utilizing bulk semiconductor wafers, the latter resulting in thin-film solar cells. Thin-film solar cell modules can be produced using a substrate technology or a superstrate technology. Silicon thin-film modules on glass may be from the superstrate type in which the active layers are deposited e.g. on a glass/TCO (transparent conductive oxide) substrate, in particular on a glass substrate covered with a TCO layer.

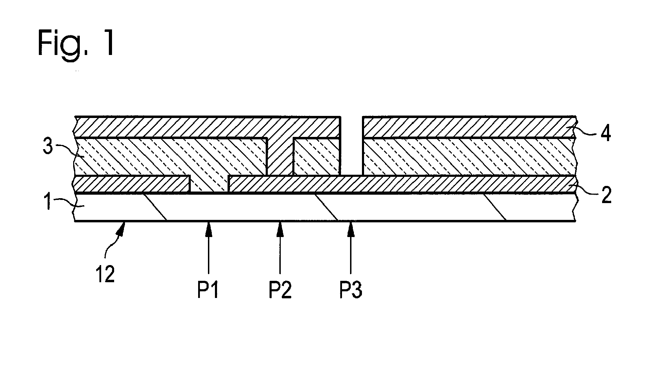

The interconnection scheme of thin-film solar cell modules is typically formed by three separate laser steps, such as indicated in the example of Fig. 1. In a first laser step P1, a front contact 2, e.g. a TCO layer, which is formed on a glass plate 1, is patterned with a laser from a front contact side 12 through the glass plate 1. Thereby, the front contacts are isolated. Subsequently, an active silicon layer 3, e.g. a-Si, a-Si/µc-Si-tandem stack, is deposited and again patterned with a laser in a second laser step P2 from the front contact side 12. Thereby, the active silicon layer is opened for a subsequent interconnection of neighboring solar cells. Then, a further layer or layer stack, e.g. including TCO and/or metal layers, is deposited as a so-called back contact 4 and fills the P2 pattern. This results in the interconnection of the back contact of a solar cell to the front contact of a neighboring solar cell. Finally, the back contact is patterned, in some examples together with the active layer 3, in a third laser step P3 from the front contact side 12. Thereby, the back contacts are isolated. Such a process results in a plurality of solar cells deposited on the glass plate, e.g. cut into cell stripes, and serially connected to each other. For interconnection of the solar cells, the second laser step provides the connection between the front contact and the back contact and hence is crucial for forming the serial connection.

### SUMMARY

In light of the above, a method of manufacturing a semiconductor device module according to claim 1, a semiconductor device connecting device according to claim 11, a semiconductor device module manufacturing device according to claim 15, and a semiconductor device module according to claim 16 are provided.

In one embodiment, a method of manufacturing a semiconductor device module including a number of n semiconductor devices is provided, n being an integer ≥ 2, the method including a step of providing a substrate coated with a first contact layer, and at least one step chosen from forming a semiconductor layer on the first contact layer and forming a second contact layer on the semiconductor layer; wherein the method includes a step of forming a connection of the first contact layer and the second contact layer by forming a number of n-1 conductive paths in a material of the semiconductor layer for connecting the n semiconductor devices.

According to another embodiment, a semiconductor device connecting device for manufacturing a semiconductor device module is provided, the semiconductor device module including a number of n semiconductor devices and including a substrate coated with a first contact layer, a semiconductor layer on the first contact layer, and a second contact layer on the semiconductor layer, and a number of n-1 conductive paths in a material of the semiconductor layer for connecting the n semiconductor devices, n being an integer ≥ 2; the semiconductor device connecting device including a first contact and second contact connection device adapted to perform a step of forming a connection of the first contact layer and the second contact layer by forming a number of n-1 conductive paths in the material of the semiconductor layer for connecting the n semiconductor devices.

In one embodiment, a semiconductor device module manufacturing device for manufacturing a semiconductor device module is provided, including a semiconductor device connecting device for manufacturing a semiconductor device module; the semiconductor device module including a number of n semiconductor devices and including a substrate coated with a first contact layer, a semiconductor layer on the first contact layer, and a second contact layer on the semiconductor layer, and a number of n-1 conductive paths in a material of the semiconductor layer for connecting the n semiconductor devices, n being an integer ≥ 2; the semiconductor device connecting device including a first contact and second contact connection device adapted to perform a step of forming a connection of the first contact layer and the second contact layer by forming a number of n-1 conductive paths in the material of the semiconductor layer for connecting the n semiconductor devices.

In another embodiment, a semiconductor device module obtainable by a method of manufacturing a semiconductor device module including a number of n semiconductor devices, n being an integer ≥ 2, is provided, the method including a step of providing a substrate coated with a first contact layer, and at least one step chosen from forming a semiconductor layer on the first contact layer and forming a second contact layer on the semiconductor layer; wherein the method includes a step of forming a connection of the first contact layer and the second contact layer by forming a number of n-1 conductive paths in a material of the semiconductor layer for connecting the n semiconductor devices.

Further features and details are evident from the dependent claims, the description and the drawings.

Embodiments are also directed to apparatuses for carrying out the disclosed methods and including apparatus parts for performing described method steps. Furthermore, embodiments are also directed to methods by which the described apparatus operates or by which the described apparatus is manufactured. They may include method steps for carrying out functions of the apparatus or manufacturing parts of the apparatus. The method steps may be performed by way of hardware components, firmware, software, a computer programmed by appropriate software, by any combination thereof or in any other manner.

### BRIEF DESCRIPTION OF THE DRAWINGS

So that the manner in which the above recited features of embodiments can be understood in detail, a more particular description of embodiments of the invention, briefly summarized above, may be had by reference to examples of embodiments. The accompanying drawings relate to embodiments of the invention and are described in the following. Some of the above mentioned embodiments will be described in more detail in the following description of typical embodiments with reference to the following drawings in which:

Fig. 1 schematically illustrates part of a semiconductor device module formed by method of manufacturing a semiconductor device;

Fig. 2a schematically illustrates a method of manufacturing a semiconductor device according to embodiments;

Fig. 2b schematically illustrates a method of manufacturing a semiconductor device according to embodiments;

Fig. 3a schematically illustrates part of a semiconductor device module according to embodiments and formed by a method of manufacturing a semiconductor device according to embodiments;

Fig. 3b schematically illustrates a method according to embodiments by which the semiconductor module according to Fig. 3a may be formed;

Fig. 4a schematically illustrates part of a semiconductor device module according to embodiments and formed by a method of manufacturing a semiconductor device according to embodiments;

Fig. 4b schematically illustrates a method according to embodiments by which the semiconductor module according to Fig. 4a may be formed; and

Fig. 5 schematically illustrates a semiconductor device module manufacturing device including a semiconductor device connecting device according to embodiments.

It is contemplated that elements of one embodiment may be advantageously utilized in other embodiments without further recitation.

### DETAILED DESCRIPTION OF THE DRAWINGS

Reference will now be made in detail to the various embodiments, one ore more examples of which are illustrated in the figures. Each example is provided by way of explanation, and is not meant as a limitation of the invention.

Without limiting the scope, in the following the examples and embodiments of the method of manufacturing a semiconductor device module, of the semiconductor device connecting device, and of the semiconductor device module manufacturing device are described referring to the manufacture and interconnection of a thin-film solar cell module. Other typical applications of embodiments described herein are for example in solar wafer manufacturing, in semiconductor device production and in the production of displays, such as LCD, TFT displays and OLED (Organic Light Emitting Diode).

Within the following description of the drawings, the same reference numbers refer to the same components. Generally, only the differences with respect to the individual embodiments are described. In embodiments described herein, the term "substrate" may refer to a rigid or a flexible substrate, such as a rigid plate or a flexible web.

According to one embodiment, a method of manufacturing a semiconductor device module including a number of n semiconductor devices, n being an integer ≥ 2, includes a step of providing a substrate coated with a first contact layer, and at least one step chosen from forming a semiconductor layer on the first contact layer and forming a second contact layer on a or the semiconductor layer; wherein the method includes a step of forming a connection of the first contact layer and the second contact layer by forming a number of n-1 conductive paths in a material of the semiconductor layer for connecting the n semiconductor devices. In some embodiments, the conductive paths can be formed within the semiconductor layer. In further embodiments, which can be combined by any other embodiments described herein, the conductive paths can be formed by modifying the semiconductor layer material. In other embodiments, which can be combined by any other embodiment described herein, the conductive paths can be formed by modifying the semiconductor layer material in the region of the conductive paths.

In one embodiment, a method of manufacturing a semiconductor device module including a number of n semiconductor devices is provided, n being an integer ≥ 2, the method including: providing a substrate coated with a first contact layer, having a semiconductor layer formed on the first contact layer, and having a second contact layer formed on the semiconductor layer; and connecting the first contact layer and the second contact layer by forming a number of n-1 conductive paths in the semiconductor layer for connecting the n semiconductor devices.

According to a further embodiment, a method of manufacturing a semiconductor device module including a number of n semiconductor devices is provided, n being an integer ≥ 2, the method including: providing a substrate coated with a first contact layer, depositing a semiconductor layer on the first contact layer, depositing a second contact layer on the semiconductor layer, and thereafter connecting the first contact layer and the second contact layer by forming a number of n-1 conductive paths in the semiconductor layer for connecting the n semiconductor devices.

According to another embodiment, a semiconductor device connecting device for manufacturing a semiconductor device module is provided, the semiconductor device module including a number of n semiconductor devices and including a substrate coated with a first contact layer, a semiconductor layer on the first contact layer, and a second contact layer on the semiconductor layer, and a number of n-1 conductive paths in a material of the semiconductor layer for connecting the n semiconductor devices, n being an integer ≥ 2; the semiconductor device connecting device including a first contact and second contact connection device adapted to perform a step of forming a connection of the first contact layer and the second contact layer by forming a number of n-1 conductive paths in the material of the semiconductor layer for connecting the n semiconductor devices. The semiconductor device module may be a solar cell module. In one embodiment, a semiconductor device module manufacturing device for manufacturing a semiconductor device module includes the semiconductor device connecting device according to any of the embodiments described herein. In some embodiments, which can be combined with any other embodiment described herein, the semiconductor device connecting device and/or the semiconductor device module manufacturing device can include a plurality of installations, e.g. chambers. At least one of the installations can be for performing only one step of the method of manufacturing a semiconductor device module. For instance, one of the installations can include the first contact and second contact connection device. Thereby, the step of connecting the first contact layer and the second contact layer by forming a number of n-1 conductive paths in the semiconductor layer can be performed separate from other steps of the method of manufacturing a semiconductor device module.

According to another embodiment, a semiconductor device connecting device for manufacturing a semiconductor device module is provided, the semiconductor device module including a number of n semiconductor devices and including a substrate coated with a first contact layer, a semiconductor layer on the first contact layer, and a second contact layer on the semiconductor layer, and a number of n-1 conductive paths in the semiconductor layer for connecting the n semiconductor devices, n being an integer ≥ 2; the semiconductor device connecting device including a first contact and second contact connection device adapted to perform a step of connecting the first contact layer and the second contact layer after forming of the second contact layer by forming the n-1 conductive paths in the semiconductor layer. For instance, the semiconductor device connecting device of embodiments may be adapted to perform any of the embodiments of methods described herein.

In some embodiments, which may be combined with any other embodiment described herein, the semiconductor devices are at least one element chosen from solar cells, thin-film solar cells, thin-film solar cells of the substrate type, and thin-film solar cells of the superstrate type. In some embodiments, which may be combined with any other embodiment described herein, the substrate is a transparent substrate, the substrate is a glass substrate, the semiconductor layer is an active layer of a solar cell, the first contact layer is a front contact layer, and/or the second contact layer is a back contact layer.

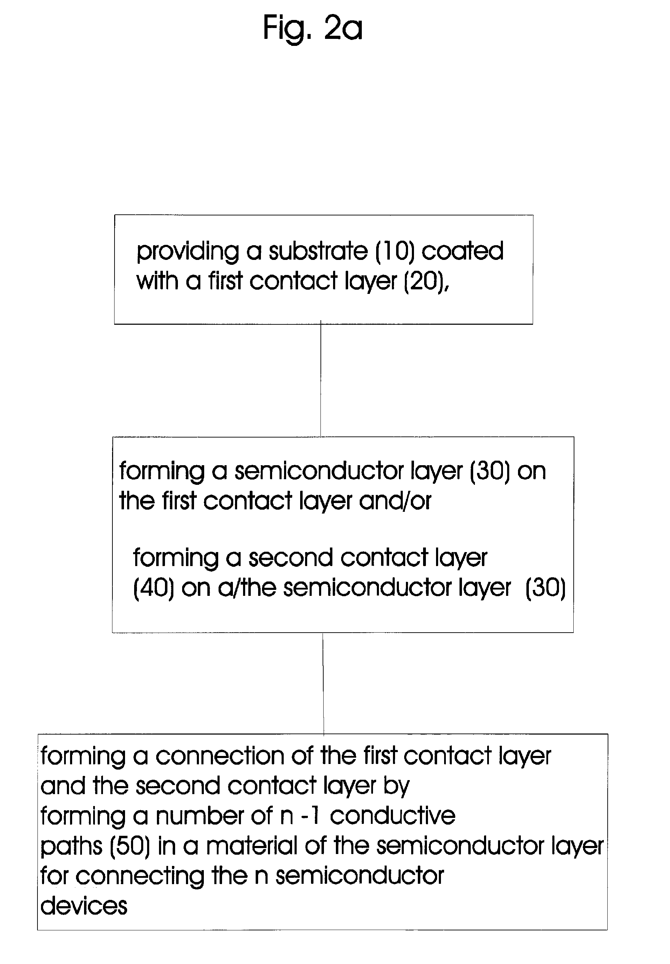

In a further embodiment, a method of manufacturing a solar cell module including a number of n solar cells is provided, n being an integer ≥ 2, the method including: providing a substrate coated with a first contact layer, having an active layer formed on the first contact layer, and having a second contact layer formed on the active layer, and connecting the first contact layer and the second contact layer by forming a number of n-1 conductive paths in the active layer for connecting the n solar cells. An example of this method is shown in Fig. 2a. In some embodiments, the step of providing a substrate coated with a first contact layer, an active layer formed on the first contact layer, a second contact layer formed on the active layer may include: providing a substrate coated with a first contact layer, depositing an active layer on the first contact layer, depositing a second contact layer on the active layer.

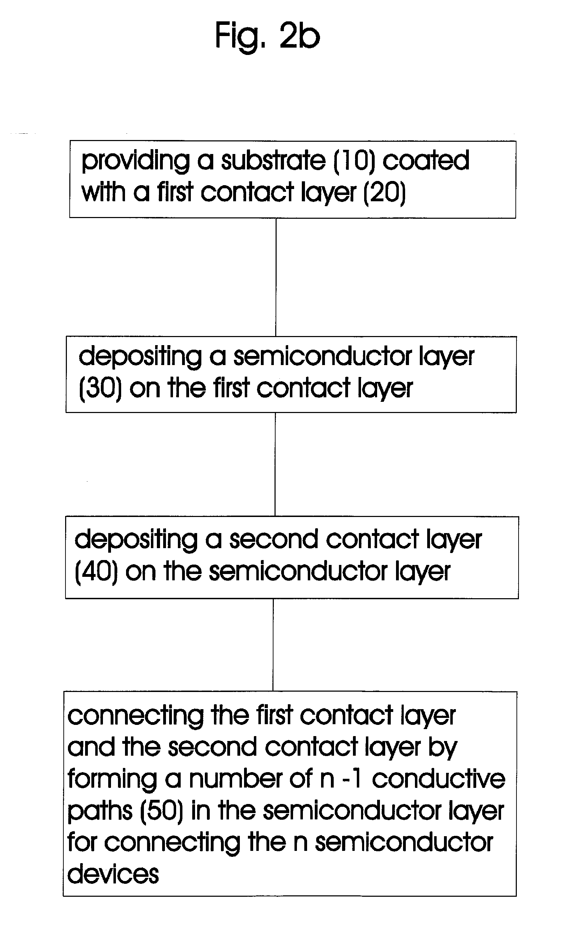

In one embodiment, a method of manufacturing a solar cell module including a number of n solar cells is provided, n being an integer ≥ 2, the method including: providing a substrate coated with a first contact layer, depositing an active layer on the first contact layer, depositing a second contact layer on the active layer, and thereafter connecting the first contact layer and the second contact layer by forming a number of n-1 conductive paths in the active layer for connecting the n solar cells. An example of this method is shown in Fig. 2b. The step of providing a substrate coated with a first contact layer may include providing a substrate and depositing a first contact layer on the substrate.

In some embodiments, which may be combined with any other embodiment described herein, the substrate may be a glass substrate and/or the semiconductor layer or active layer may be a silicon layer. Further, the first contact layer and/or the second contact layer may be transparent and/or may include or consist of a TCO. Moreover, the first contact layer may be a front contact layer and the second contact layer may be a back contact layer, e.g. corresponding to a superstrate structure.

A further embodiment is a solar cell module manufacturing device for manufacturing a solar cell module, the solar cell module including a number of n solar cells and including a glass substrate coated with a first contact layer, an active layer on the first contact layer, and a second contact layer on the active layer, and a number of n-1 conductive paths in the active layer for connecting the n solar cells, n being an integer ≥ 2; the solar cell module manufacturing device including a first contact and second contact connection device adapted to perform a step of connecting the first contact layer and the second contact layer after forming of the second contact layer by forming the n-1 conductive paths in the active layer, e.g. according to a method of any embodiment described herein.

Embodiments disclosed herein allow for forming a serial connection of neighboring semiconductor devices of a module, e.g. a connection between the front contact and the back contact of neighboring thin-film solar cells, after forming or deposition of the contact layer which is formed at last, rather than before. For instance, when manufacturing a thin-film solar cell of the superstrate type, the serial connection between the front contact and the back contact of two neighboring solar cells can be formed after forming or deposition of the back contact layer, rather than before back contact layer deposition. That means that a patterning of the semiconductor layer, e.g. the active silicon layer of a silicon solar cell, can be omitted. Rather than forming a groove by removing the semiconductor layer in the second laser step P2, as indicated in Fig. 1, and then filling the groove with the second contact layer, the connection between the first and the second contact can be formed by providing a conductive path after second contact deposition. This is achieved by treatment of components of the semiconductor layer, the first contact layer and/or the second contact layer. Thereby, the total process time of manufacturing a semiconductor module, e.g. a thin-film solar cell module and, hence, the manufacturing cost can be reduced. Further, the alignment of the first and second contact interconnection and the front contact isolation and/or back contact isolation structures of the module can be improved. This reduces the so-called dead area loss and, hence, can improve the module performance.

According to further embodiments, rather than forming a groove by removing the semiconductor layer in the second laser step P2, as indicated in Fig. 1, and then filling the groove with the second contact layer, the connection between the first and the second contact can be formed by providing a conductive path in the material of the semiconductor layer, also referred to herein as providing a conductive path in the semiconductor layer, before second contact deposition. This is achieved by treatment of components of the semiconductor layer and/or the first contact layer. That means that a patterning of the semiconductor layer, e.g. the active silicon layer of a silicon solar cell, can be omitted.

According to any embodiment described herein, the conductive paths may be formed by selectively treating, e.g. heating, at least one of the first contact layer, the semiconductor layer and the second contact layer, e.g. by exposure to radiation, such as IR, UV, laser, electromagnetic radiation or exposure to particle beams, or by inductive heating.

In one embodiment, which can be combined with any other embodiment described herein, the conductive paths are formed by laser treatment. For instance, depending on the materials of at least one of the first contact layer, the semiconductor layer and the second contact layer, by choice of an appropriate wavelength of laser light, the laser light is absorbed in at least one of the first contact layer, the semiconductor layer and the second contact layer. Thereby, a selective laser treatment of at least one of these layers, e.g. solely in the semiconductor layer, can be achieved. In addition, other properties of the layers and/or of the laser light may be chosen and/or varied for obtaining a desired laser treatment of one or more of the layers, in order to form the conductive paths. Examples of such settings and properties are: layer thickness, laser power, type of laser, pulse mode, pulse sequence, overlap of pulses, and length of pulses.

Moreover, according to embodiments, the conductive paths may be formed by at least one process chosen from melting at least one of the layers, mixing at least one of the layers, reacting components of at least one of the layers, activating at least one component of at least one of the layers, diffusing components of at least one of the layers, and partially removing at least one of the layers, the layers being at least one layer chosen from the first contact layer, the semiconductor layer and the second contact layer. The melding, mixing, reacting, activating and diffusion may be performed selectively, for instance restricted to the area in which the interconnection between the first and the second contacts is to be formed, and/or restricted to some of the layers and/or some components of the layers.

When forming the conductive paths, one or all layers, i.e. at least one layer of the second contact layer, the semiconductor layer and the first contact layer, may be at least partially molten at or near the position, at which the interconnection of the first and second contacts is to be formed. Thereby, the molten components or materials can be mixed to form a conductive path. Alternatively or in addition, components or materials of layers involved can be mixed at or near the intended position of the first and second contact interconnection by diffusion of components, such as atoms or molecules, of the respective layers, without melting the layers. The diffusion process, when using a laser treatment for forming the conductive path, may be called laser firing.

For instance, metal atoms and/or conductive oxide components of the second contact layer and/or the first contact layer may be mixed or diffused into the semiconductor layer, such that conductive paths between the first contact layer and the second contact layer are formed in the material of the semiconductor layer. For instance, Al filaments may be created in the semiconductor layer by diffusing Al from the second contact layer into the semiconductor layer. In other examples, for instance doped semiconductor layer regions, e.g. Al doped Si regions, which are conductive at ambient temperatures, may be formed as conductive paths in the semiconductor layer. Alternatively, only components of the semiconductor layer may be treated to form the conductive paths, e.g. by reaction and/or activation. For instance, a precursor of the semiconductor layer including Cd and Te or Ga and As and Al can be treated to result in a CdTe or GaAs semiconductor layer having conductive Al paths. Further, a conductive oxide may be formed in the semiconductor layer as a conductive path, e.g. by mixing or diffusing and/or reacting/activating components of the semiconductor layer and/or some of the adjacent layers. For instance, ZnO or Zn and O may be diffused into a semiconductor layer, which includes In, and thereby In doped ZnO regions, which are conductive, may be established in the semiconductor layer. Alternatively, the intermixing, interdiffusion and/or reaction of the layers may result in conductive paths including or consisting of a conductive metal organic compound.

In one example, Si material of an amorphous Si semiconductor layer may be reacted with Al, which is diffused from the second contact layer into the semiconductor layer. Thereby, for instance conductive Al regions, conductive Al bridges, conductive so called Al filaments, conductive Al oxide spikes, conductive Si spikes, Al doped Si, and/or conductive crystalline Si regions can be formed in the semiconductor layer. By establishing such conductive regions in the semiconductor layer, the conductive paths of embodiments described herein may be formed.

Further, an additional step of partially removing some of the layers may be added to or included in the step of forming the conductive paths. According to one example of embodiments, before forming the conductive paths, a part of the second contact layer may be removed at the desired positions of the first and second contact interconnections, for instance by laser treatment, such as evaporation or ablation. Then, the semiconductor layer, the first contact layer, and/or the second contact layer is/are treated to form the conductive path in the material of the semiconductor layer. Thereafter, parts of the second contact layer, which were not removed, may be molten to cover the formed conductive paths. In one example, the conductive path may be formed during laser treatment for removal of part of the second contact layer.

In other embodiments, which can be combined with any other embodiment described herein, the first contact layer may be a layer or layer stack in which at least one of the layers includes at least one element chosen from TCO and a metal, such as Cu or Ag. For instance, when the semiconductor device is to be formed in a superstrate configuration, the first contact layer may consist of TCO. Moreover, in some embodiments, which can be combined with any other embodiment described herein, the semiconductor layer may be a layer or layer stack in which at least one of the layers includes at least one element chosen from amorphous Si (a-Si), microcrystalline Si (µc-Si), and an a-Si/µc-Si-tandem stack. In other embodiments, which can be combined with any other embodiment described herein, the second contact layer may be a layer or layer stack in which at least one of the layers includes at least one element chosen from TCO and a metal, such as Cu, Al or Ag.

In some embodiments, at least one layer selected from the first contact layer and the second contact layer includes a transparent conductive oxide. Examples of TCO are ITO (Indium Tin Oxide), ZnO, and SnO.

In some embodiments, the first contact layer includes at least a TCO, the second contact layer includes at least one material chosen from a TCO or a metal, such as Al or Ag, and/or the semiconductor layer includes at least one material chosen from Si, amorphous Si (a-Si), microcrystalline Si (µc-Si), GaAs, CdTe and CuInSe.

In some embodiments, at least one laser treatment is performed from at least one side chosen from a side of the first contact and a side of the second contact. For instance, the laser treatment can be performed either from a first contact side and/or from a second contact side of the substrate coated with the stack of the first contact layer, the semiconductor layer and the second contact layer. E.g. the laser treatment may be conducted either through the substrate and the stack of the substrate and the first contact layer, respectively, or through the second contact layer. In one example, a semiconductor device module precursor may be treated by laser irradiation from both sides of the substrate/contact layer(s) stack.

According to some embodiments, the method further includes at least one step chosen from: forming a number of n-1 first grooves in the first contact layer after the step of providing the substrate coated with the first contact layer, filling the first grooves with an insulating material or, during the step of depositing the semiconductor layer, filling the first grooves with the semiconductor layer; forming a number of n-1 second grooves in the second contact layer; forming a number of n-1 second grooves in the semiconductor layer, and forming a number of n-1 second grooves in the second contact layer and/or the semiconductor layer for separating neighboring semiconductor devices. The step of forming the number of n-1 second grooves may be performed after or before the step of connecting the first contact layer and the second contact layer. Further, at least two steps chosen from connecting the first contact layer and the second contact layer, forming the first grooves, forming the second grooves in the second contact layer, forming the second grooves in the semiconductor layer, and forming the second grooves in the second contact layer and/or the semiconductor layer may be performed simultaneously. In some embodiments, the first grooves may extend throughout the first contact layer to the substrate. In further embodiments, the second grooves may extend throughout the second contact layer and the semiconductor layer to the first contact layer.

In one embodiment, during forming of the conductive path by treating the second contact layer, the first contact layer and/or the semiconductor layer, the interfaces of the conductive path may become conductive. For instance, the materials of the second contact layer and the semiconductor may melt and the material of the second contact layer may be intermixed into the semiconductor layer, forming a region of the material of the second contact layer in the semiconductor layer. Thereby, at the interfaces or contact areas of the two different materials conductive regions may be formed, resulting in a conductive path.

In one method according to embodiments described herein, at least one step chosen from forming the first grooves, connecting the first contact layer and the second contact layer, forming the second grooves in the second contact layer, forming the second grooves in the semiconductor layer and forming the second grooves in the second contact layer and/or the semiconductor layer is performed by laser treatment. At least one laser treatment may be performed from the first contact side and/or from the second contact side.

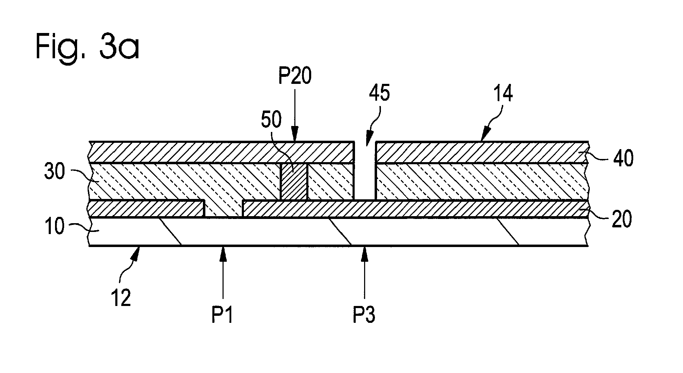

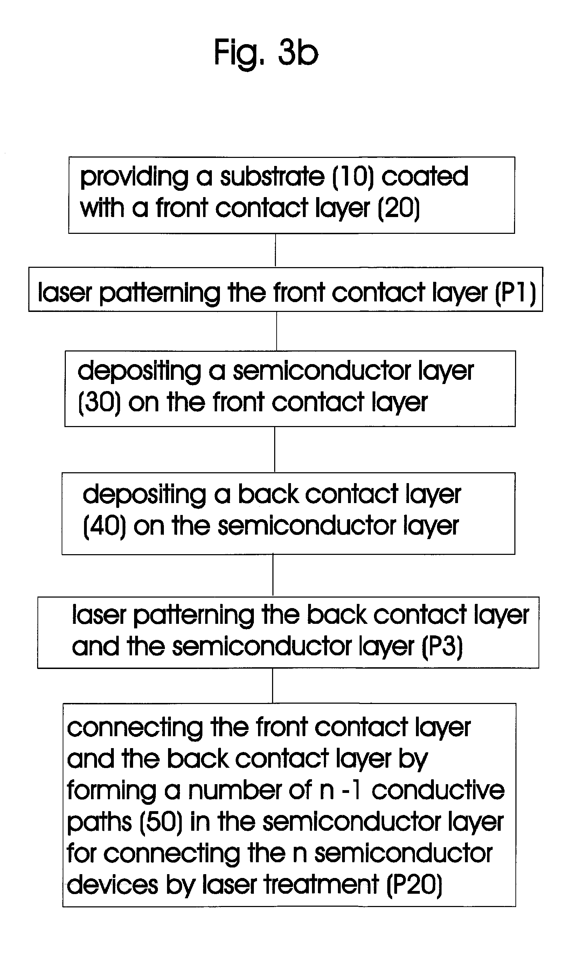

According to one example of embodiments, the interconnection scheme of a thin-film solar cell module, as shown in Fig. 3a, is formed by three laser steps in a method such as illustrated in Fig. 3b. In a first laser step P1, as a first contact layer, a front contact layer 20, which is a TCO layer, for instance SnO or ZnO, and is formed on a glass plate 10 as a substrate, is linearly patterned with a laser from a front contact side 12, i.e. through the glass substrate 10. The laser has for instance settings of a wavelength of 1064 nm, overlapping single laser spots and a pulse frequency between 10 kHz and 150 kHz. Thereby, the front contacts of individual solar cells are isolated. Subsequently, as a semiconductor layer, an active silicon layer 30, which substantially consists of a-Si, is deposited on the front contact layer. Then, in the present example, a ZnO, Al, NiV layer system is deposited as a so-called back contact 40 on the active silicon layer 30. Then, the back contact layer 40 is linearly patterned together with the active layer 30 in a laser step P3 from the front contact side 12, i.e. through the glass plate 10. Thereby, the back contacts of individual solar cells are isolated by forming linear grooves 45 in the back contact layer 40 and the active layer 30. For interconnection of the solar cells, a further laser step P20 performed from a back contact side 14 provides the connection between the front contacts 20 and the back contacts 40. This induces melting and intermixing of the active layer 30 and the back contact layer 40 at the positions, in the present example each a line, at which the interconnections between the front contact and the back contact of neighboring solar cells are to be formed. Thereby, in the active silicon layer linear conductive paths 50 including ZnO, Al, NiV are formed extending from the front contact of a solar cell to the back contact of a neighboring solar cell as an interconnection. Such a process results in a plurality of solar cells deposited on the glass plate, cut into cell stripes, and serially connected to each other by a plurality of conductive paths. According to a variation of this example of embodiments, in the laser step P3, the back contact layer 40 can be patterned without patterning of the active layer 30.

According to another example of embodiments, the interconnection scheme of a thin-film solar cell module, as shown in Fig. 3a, is formed by three laser steps in a method such as illustrated in Fig. 3b. In a first laser step P1, as a first contact layer, a front contact layer 20, which is a TCO layer, for instance ZnO, and is formed on a glass plate 10 as a substrate, is linearly patterned with a laser from a front contact side 12, i.e. through the glass substrate 10. The laser has for instance settings of a wavelength of 1064 nm, overlapping single laser spots and a pulse frequency between 10 kHz and 150 kHz. Thereby, the front contacts of individual solar cells are isolated. Subsequently, as a semiconductor layer, an active silicon layer 30, which substantially consists of a-Si, is deposited on the front contact layer. Then, in the present example, an Al metal layer is deposited as a so-called back contact 40 on the active silicon layer 30. Then, the back contact layer 40 is linearly patterned together with the active layer 30 in a laser step P3 from the front contact side 12, i.e. through the glass plate 10. Thereby, the back contacts of individual solar cells are isolated by forming linear grooves 45 in the back contact layer 40 and the active layer 30. For interconnection of the solar cells, a further laser step P20 performed from a back contact side 14 provides the connection between the front contacts 20 and the back contacts 40. This induces diffusing of the back contact layer 40 into the active layer 30 at the positions, in the present example each a line, at which the interconnections between the front contact and the back contact of neighboring solar cells are to be formed. Thereby, in the active silicon layer linear conductive paths 50 including Al are formed extending from the front contact of a solar cell to the back contact of a neighboring solar cell as an interconnection. Such a process results in a plurality of solar cells deposited on the glass plate, cut into cell stripes, and serially connected to each other by a plurality of conductive paths. According to a variation of this example of embodiments, in the laser step P3, the back contact layer 40 can be patterned without patterning of the active layer 30.

According to embodiments, other patterns than linear patterns formed by the laser steps or other than linear conductive paths may be formed. In some embodiments, which can be combined with any other embodiment described herein, at least one element chosen from a pattern formed by at least one of the laser steps and at least one of the conductive paths may have a linear form or a punctual form.

According to some embodiments, which can be combined with any other embodiment described herein, at least one element chosen from the conductive paths, the first grooves and the second grooves are formed in parallel to each other.

According to one embodiment, at least the steps of connecting the first contact layer and the second contact layer and forming the second grooves in the second contact layer and/or the semiconductor layer may be performed simultaneously, or at least in the same tool, e.g. in a first contact and second contact connection device of embodiments described herein. According to one embodiment, at least the steps of connecting the first contact layer and the second contact layer and forming the second grooves in the second contact layer may be performed simultaneously, or at least in the same tool, e.g. in a first contact and second contact connection device of embodiments described herein.

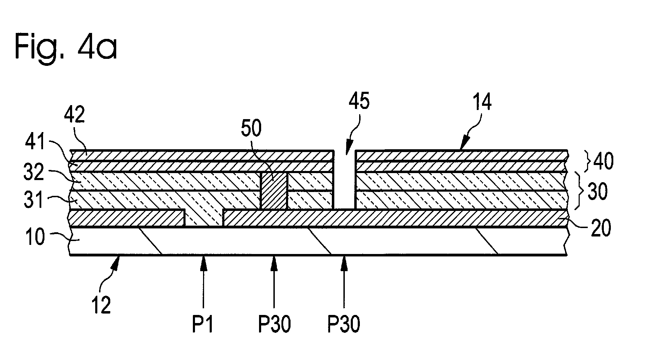

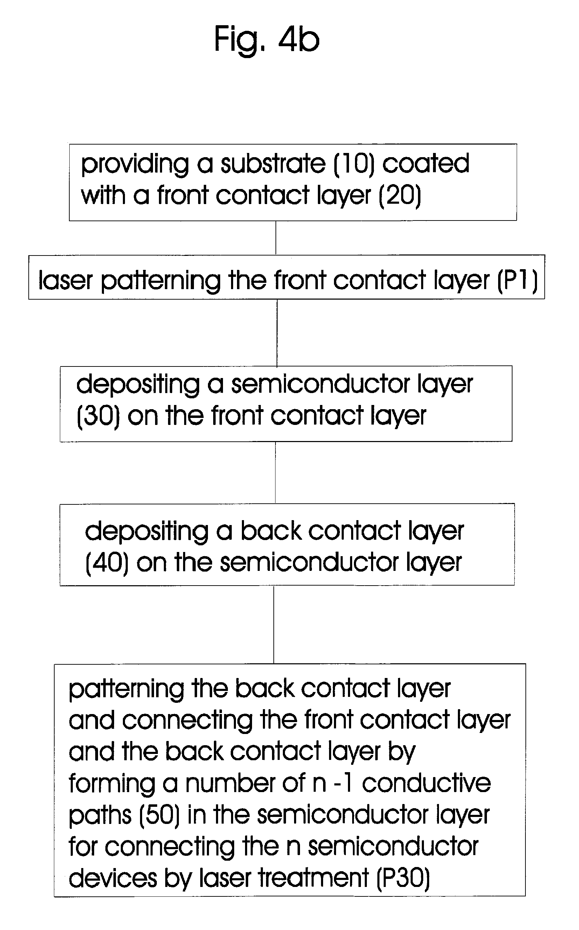

According to another example of embodiments, the interconnection scheme of a thin-film solar cell module, such as indicated in Fig. 4a, is formed by two separate laser steps in a method illustrated in Fig. 4b. In a first laser step P1, the front TCO contact layer 20, which is a ZnO layer in this example and which is formed on a glass plate 10 as a substrate, is patterned with a laser from the front contact side 12. Thereby, the front contacts are isolated. Then, as a semiconductor layer, the active silicon layer 30, in the present example an a-Si/µc-Si-tandem stack 31, 32, is deposited on the front contact layer 20. A further layer stack, in the present example including a ZnO layer 41 and an Ag, NiV layer stack 42, is deposited as the back contact layer 40 on the active silicon layer 30. Finally, the back contact layer 40 is patterned and treated together with the active layer 30 in a third laser step P30 performed from the front contact side 12 of the substrate/layer stack. Thereby, the grooves 45 are formed in the back contact layer 40 and the active layer 30, such that the back contacts of individual solar cells are isolated. Simultaneously, during laser step P30, components of the front TCO contact layer 20 diffuse into the layers 31 and 32 of the active layer 30 at the locations, at which the interconnections are to be formed. Thereby, the conductive paths 50 are formed. This process results in a plurality of solar cells deposited on the glass plate 10 and serially connected to each other.

In other embodiments, which can be combined with any other embodiment described herein, the conductive paths 50 formed may include at least one material chosen from a conductive mixture, a conductive alloy, a conductive reaction product or a conductive diffusion product.

According to other embodiments, a semiconductor device connecting device for manufacturing a semiconductor device module is provided. The semiconductor device module of embodiments includes a number of n semiconductor devices and includes a substrate coated with a first contact layer, a semiconductor layer on the first contact layer, and a second contact layer on the semiconductor layer, and a number of n-1 conductive paths in a material of the semiconductor layer for connecting the n semiconductor devices, n being an integer ≥ 2. The semiconductor device connecting device of embodiments includes a first contact and second contact connection device adapted to perform a step of forming a connection of the first contact layer and the second contact layer by forming a number of n-1 conductive paths in the material of the semiconductor layer for connecting the n semiconductor devices.

According to one embodiment, a semiconductor device connecting device for manufacturing a semiconductor device module is provided, the semiconductor device module including a number of n semiconductor devices and including a substrate coated with a first contact layer, a semiconductor layer on the first contact layer, and a second contact layer on the semiconductor layer, and a number of n-1 conductive paths in the semiconductor layer for connecting the n semiconductor devices, n being an integer ≥ 2; the semiconductor device connecting device including a first contact and second contact connection device adapted to perform a step of connecting the first contact layer and the second contact layer after forming of the second contact layer by forming the n-1 conductive paths in the semiconductor layer, e.g. according to any of herein described embodiments of methods.

According to some embodiments, which can be combined with any other embodiment or example of embodiment described herein, the first contact and second contact connection device is part of a vacuum installation. According to some embodiments, which can be combined with any other embodiment or example of embodiment described herein, the first contact and second contact connection device is not part of a vacuum installation.

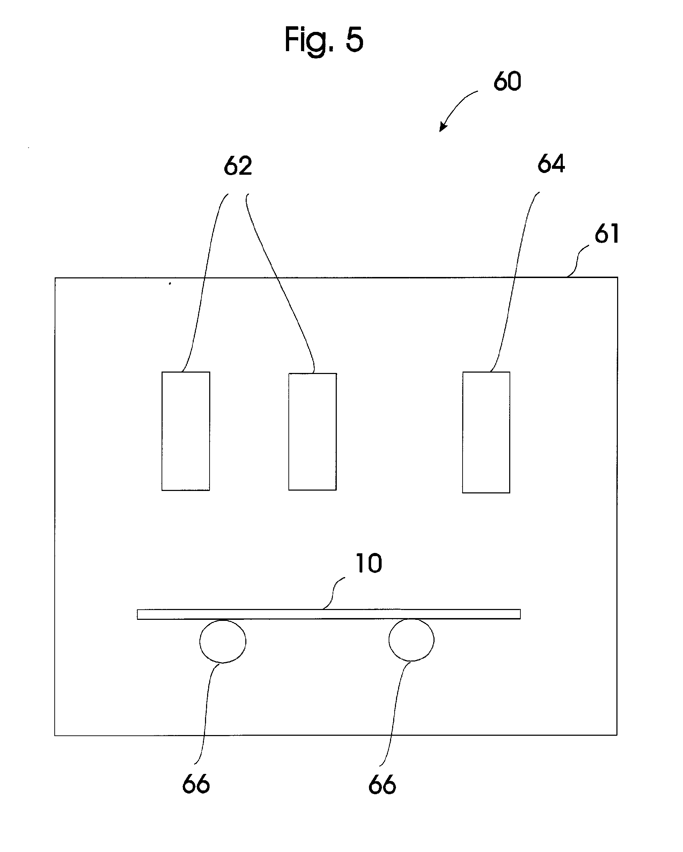

As an example, a semiconductor device module manufacturing device 60 according to embodiments is schematically shown in Fig. 5. The semiconductor device module manufacturing device 60 includes a housing 61. In the housing 61 one or more coating devices 62, a semiconductor device connecting device and a transport system, e.g. including transport rolls 66 for conveying the substrate 10, are provided. According to this example, the semiconductor device connecting device includes a laser device 64 as the first contact and second contact connection device adapted to perform the step of connecting the first contact layer and the second contact layer after deposition of the second contact layer by forming the n-1 conductive paths in the material of the semiconductor layer according to embodiments. As shown in Fig. 5, on the transport rolls 66, the substrate 10, e.g. coated with a front contact layer (not shown), may be transported below the coating devices 62 and the laser device 64 from the left to the right. Thereby, steps of the methods according to embodiments described herein, e.g. of the methods illustrated in Figs. 3b and 4b, may be performed. In one embodiment of the semiconductor device module manufacturing device 60, the coating devices 62 and the semiconductor device connecting device 64 are provided in different chambers through which the transport system conveys the substrate to be coated. For instance, the coating devices 62 and the semiconductor device connecting device 64 are provided in different sub-chambers of the housing 61, which are separately pumped and may be connected to each other via slots, e.g. slit valves, through which the transport system conveys the substrates to be coated and treated. In another modification, the laser device 64 may include one or more laser sources, which may be provided in different chambers. According to one example of embodiments, the housing 61 may be a vacuum installation or a vacuum chamber, or may include a plurality of vacuum installations or vacuum chambers, which may be interconnected.

In the semiconductor device connecting device, the first contact and second contact connection device may be adapted to additionally perform at least one step chosen from forming first grooves in the first contact layer, and forming second grooves in the second contact layer and/or the semiconductor layer, e.g. according to any of above described methods.

According to one embodiment of the semiconductor device connecting device, the first contact and second contact connection device includes at least one laser device provided to, e.g. successively or simultaneously, perform at least one step chosen from forming the first grooves, connecting the first contact layer and the second contact layer, and forming the second grooves in the second contact layer and/or the semiconductor layer. For instance, for performing the method illustrated in Fig. 4b, the first contact and second contact connection device may include two lasers positioned in parallel to each other for conducting the step P30, i.e. a simultaneous formation of the groove 45 and the conductive path 50.

Embodiments disclosed herein allow for forming a serial connection of neighboring semiconductor devices of a module, e.g. a connection between the front contact and the back contact of neighboring thin-film solar cells, after forming or deposition of the contact layer which is formed at last, rather than before. For instance, when manufacturing a thin-film solar cell of the superstrate type, the serial connection between the front contact and the back contact of two neighboring solar cells can be formed after forming or deposition of the back contact layer, rather than before back contact layer deposition. That means that a patterning of the semiconductor layer, e.g. the active silicon layer of a silicon solar cell, can be omitted. Rather than forming a groove by removing the semiconductor layer in the second laser step P2, as indicated in Fig. 1, and then filling the groove with the second contact, the connection between the first and the second contact is formed by creating a conductive path after second contact deposition. This is achieved by treatment of components of the semiconductor layer, the first contact layer and/or the second contact layer. Hence, the step of isolation of the second contacts, e.g. back contacts, and the step of forming the serial connection between the first and the second contacts, e.g. front and back contacts, can be performed simultaneously, for instance by laser treatment. Moreover, the tool for forming the connection between the first and the second contact, e.g. the first contact and second contact connection device of above embodiments, may be implemented in the tool for performing the step of isolation of the second contact. For instance, such implementing of two steps in the same tool eliminates one loading and alignment step. Hence, not only the total process time of manufacturing a semiconductor module, e.g. a thin-film solar cell module, but also the manufacturing and tool cost can be reduced. Further, the alignment of the first and second contact interconnections and the front contact isolation and/or back contact isolation structures of the module can be improved, e.g. by allowing smaller distances there between. This reduces the so-called dead area loss and, hence, can improve the module performance.

According to further embodiments, rather than forming a groove by removing the semiconductor layer in the second laser step P2, as indicated in Fig. 1, and then filling the groove with the second contact layer, the connection between the first and the second contact can be formed by providing a conductive path in the material of the semiconductor layer before second contact deposition. This is achieved by treatment of components of the semiconductor layer and/or the first contact layer. That means that a patterning of the semiconductor layer, e.g. the active silicon layer of a silicon solar cell, can be omitted.

In one embodiment, a method of manufacturing a semiconductor device module including a number of n semiconductor devices is provided, n being an integer ≥ 2, the method including a step of providing a substrate coated with a first contact layer, and at least one step chosen from forming a semiconductor layer on the first contact layer and forming a second contact layer on the semiconductor layer; wherein the method includes a step of forming a connection of the first contact layer and the second contact layer by forming a number of n-1 conductive paths in a material of the semiconductor layer for connecting the n semiconductor devices.

In one embodiment, a method of manufacturing a semiconductor device module including a number of n semiconductor devices is provided, n being an integer ≥ 2, the method including: providing a substrate coated with a first contact layer, having a semiconductor layer formed on the first contact layer, and having a second contact layer formed on the semiconductor layer; and connecting the first contact layer and the second contact layer by forming a number of n-1 conductive paths in the semiconductor layer for connecting the n semiconductor devices.

In one embodiment, which can be combined with any other embodiment described herein, the step of providing a substrate coated with a first contact layer, having a semiconductor layer formed on the first contact layer, and having a second contact layer formed on the semiconductor layer includes: providing the substrate coated with the first contact layer, depositing the semiconductor layer on the first contact layer, and depositing the second contact layer on the semiconductor layer.

According to one embodiment, a method of manufacturing a semiconductor device module including a number of n semiconductor devices, n being an integer ≥ 2, is provided, the method including: providing a substrate coated with a first contact layer, depositing a semiconductor layer on the first contact layer, depositing a second contact layer on the semiconductor layer, and thereafter connecting the first contact layer and the second contact layer by forming a number of n-1 conductive paths in the semiconductor layer for connecting the n semiconductor devices.

In another embodiment, a method of manufacturing a solar cell module including a number of n solar cells is provided, n being an integer ≥ 2, the method including: providing a substrate coated with a first contact layer, having an active layer formed on the first contact layer, and having a second contact layer formed on the active layer; and connecting the first contact layer and the second contact layer by forming a number of n-1 conductive paths in the active layer for connecting the n solar cells.

In one embodiment, which can be combined with any other embodiment described herein, the conductive paths are formed by laser treatment.

In one embodiment, which can be combined with any other embodiment described herein, the conductive paths are formed by at least one process chosen from melting at least one of the layers, mixing at least one of the layers, reacting components of at least one of the layers, activating at least one component of at least one of the layers, diffusing components of at least one of the layers, and partially removing at least one of the layers, the layers being at least one layer chosen from the first contact layer, the semiconductor layer and the second contact layer.

In one embodiment, which can be combined with any other embodiment described herein, the step of forming the connection of the first contact layer and the second contact layer is performed at a time chosen from: after depositing the second contact layer, and before depositing the second contact layer.

In one embodiment, which can be combined with any other embodiment described herein, the first contact layer includes at least a TCO, the second contact layer includes at least one material chosen from a TCO or a metal, and/or the semiconductor layer includes at least one material chosen from Si, a-Si, µc-Si, CdTe, GaAs and CuInSe.

In one embodiment, which can be combined with any other embodiment described herein, the semiconductor devices are at least one element chosen from solar cells, thin-film solar cells, thin-film solar cells of a substrate type, and thin-film solar cells of a superstrate type.

In some embodiments, which can be combined with any other embodiment described herein, the substrate is a transparent substrate, the substrate is a glass substrate, the semiconductor layer is an active layer of a solar cell, the first contact layer is a front contact layer, and/or the second contact layer is a back contact layer.

In one embodiment, which can be combined with any other embodiment described herein, the substrate is a glass substrate, the semiconductor layer is an active layer of a solar cell, the first contact layer is a front contact layer, and the second contact layer is a back contact layer.

In one embodiment, which can be combined with any other embodiment described herein, the method further includes at least one step chosen from: forming a number of n-1 first grooves in the first contact layer after the step of providing the substrate coated with the first contact layer, filling the first grooves with an insulating material or, during the step of depositing the semiconductor layer, filling the first grooves with the semiconductor layer; forming a number of n-1 second grooves in the second contact layer; forming a number of n-1 second grooves in the semiconductor layer; and forming a number of n-1 second grooves in the second contact layer and/or the semiconductor layer for separating neighboring semiconductor devices.

In one embodiment, which can be combined with any other embodiment described herein, the step of forming the number of n-1 second grooves is performed at a time chosen from after the step of forming the connection of the first contact layer and the second contact layer, and before the step of forming the connection of the first contact layer and the second contact layer.

In one embodiment, which can be combined with any other embodiment described herein, at least two steps chosen from forming the connection of the first contact layer and the second contact layer, forming the first grooves, forming the second grooves in the second contact layer, forming the second grooves in the semiconductor layer, and forming the second grooves in the second contact layer and/or the semiconductor layer are performed simultaneously.

In one embodiment, which can be combined with any other embodiment described herein, at least one step chosen from forming the first grooves, forming the connection of the first contact layer and the second contact layer, forming the second grooves in the second contact layer, forming the second grooves in the semiconductor layer, and forming the second grooves in the second contact layer and/or the semiconductor layer is performed by laser treatment.

In one embodiment, which can be combined with any other embodiment described herein, at least one laser treatment is performed from at least one side chosen from a side of the first contact and a side of the second contact.

In one embodiment, which can be combined with any other embodiment described herein, at least one element chosen from the conductive paths, the first grooves and the second grooves are formed in parallel to each other.

In one embodiment, which can be combined with any other embodiment described herein, at least one layer selected from the first contact layer and the second contact layer includes a transparent conductive oxide.

According to another embodiment, a semiconductor device connecting device for manufacturing a semiconductor device module is provided, the semiconductor device module including a number of n semiconductor devices and including a substrate coated with a first contact layer, a semiconductor layer on the first contact layer, and a second contact layer on the semiconductor layer, and a number of n-1 conductive paths in a material of the semiconductor layer for connecting the n semiconductor devices, n being an integer ≥ 2; the semiconductor device connecting device including a first contact and second contact connection device adapted to perform a step of forming a connection of the first contact layer and the second contact layer by forming a number of n-1 conductive paths in the material of the semiconductor layer for connecting the n semiconductor devices.

In one embodiment, which can be combined with any other embodiment described herein, the semiconductor device connecting device can include a plurality of installations, e.g. chambers and/or vacuum chambers, which may be connected to each other. According to one example of this embodiment, each of the installations can be for or can be adapted for performing one step of the method of manufacturing a semiconductor device module according to embodiments described herein. For instance, one of the installations can include the first contact and second contact connection device. Thereby, the step of connecting the first contact layer and the second contact layer by forming a number of n-1 conductive paths in the semiconductor layer, e.g. step P20, can be performed separate from other steps, e.g. step P1 and/or step P3, of the method of manufacturing a semiconductor device module.

In one embodiment, which can be combined with any other embodiment described herein, a semiconductor device module manufacturing device for manufacturing a semiconductor device module is provided, including a semiconductor device connecting device for manufacturing a semiconductor device module; the semiconductor device module including a number of n semiconductor devices and including a substrate coated with a first contact layer, a semiconductor layer on the first contact layer, and a second contact layer on the semiconductor layer, and a number of n-1 conductive paths in a material of the semiconductor layer for connecting the n semiconductor devices, n being an integer ≥ 2; the semiconductor device connecting device including a first contact and second contact connection device adapted to perform a step of forming a connection of the first contact layer and the second contact layer by forming a number of n-1 conductive paths in the material of the semiconductor layer for connecting the n semiconductor devices.

According to another embodiment, a semiconductor device module manufacturing device for manufacturing a semiconductor device module is provided, the semiconductor device module including a number of n semiconductor devices and including a substrate coated with a first contact layer, a semiconductor layer on the first contact layer, and a second contact layer on the semiconductor layer, and a number of n-1 conductive paths in a material of the semiconductor layer for connecting the n semiconductor devices, n being an integer ≥ 2; the semiconductor device module manufacturing device including a first contact and second contact connection device adapted to perform a step of forming a connection of the first contact layer and the second contact layer after forming of the second contact layer by forming the n-1 conductive paths in the material of the semiconductor layer.

In one embodiment, which can be combined with any other embodiment described herein, the first contact and second contact connection device is adapted to additionally perform at least one step chosen from forming first grooves in the first contact layer, forming second grooves in the second contact layer, forming second grooves in the semiconductor layer, and forming second grooves in the second contact layer and/or the semiconductor layer.

In one embodiment, which can be combined with any other embodiment described herein, the first contact and second contact connection device includes at least one laser device adapted to perform at least one step chosen from forming first grooves in the first contact layer, forming the connection of the first contact layer and the second contact layer, forming the second grooves in the second contact layer, forming the second grooves in the semiconductor layer, and forming second grooves in the second contact layer and/or the semiconductor layer.

In one embodiment, which can be combined with any other embodiment described herein, the first contact and second contact connection device includes at least one laser device adapted to successively perform at least one step chosen from forming the first grooves, forming the connection of the first contact layer and the second contact layer, forming the second grooves in the second contact layer, forming the second grooves in the semiconductor layer, and forming the second grooves in the second contact layer and/or the semiconductor layer.

In one embodiment, which can be combined with any other embodiment described herein, the first contact and second contact connection device includes at least one laser device adapted to simultaneously perform at least one step chosen from forming the first grooves, forming the connection of the first contact layer and the second contact layer, forming the second grooves in the second contact layer, forming the second grooves in the semiconductor layer, and forming the second grooves in the second contact layer and/or the semiconductor layer.

In one embodiment, which can be combined with any other embodiment described herein, the semiconductor devices are at least one element chosen from solar cells, thin-film solar cells, thin-film solar cells of a substrate type, and thin-film solar cells of a superstrate type.

In one embodiment, which can be combined with any other embodiment described herein, the substrate is a glass substrate, the semiconductor layer is an active layer of a solar cell, the first contact layer is a front contact layer, and/or the second contact layer is a back contact layer.

Some embodiments provide a semiconductor device module obtainable or obtained by a method of any embodiment described herein.

In another embodiment, a semiconductor device module obtainable by a method of manufacturing a semiconductor device module including a number of n semiconductor devices, n being an integer ≥ 2, is provided, the method including a step of providing a substrate coated with a first contact layer, and at least one step chosen from forming a semiconductor layer on the first contact layer and forming a second contact layer on the semiconductor layer; wherein the method includes a step of forming a connection of the first contact layer and the second contact layer by forming a number of n-1 conductive paths in a material of the semiconductor layer for connecting the n semiconductor devices.

In another embodiment, a semiconductor device module obtained by a method of manufacturing a semiconductor device module including a number of n semiconductor devices, n being an integer ≥ 2, is provided, the method including a step of providing a substrate coated with a first contact layer, and at least one step chosen from forming a semiconductor layer on the first contact layer and forming a second contact layer on the semiconductor layer; wherein the method includes a step of forming a connection of the first contact layer and the second contact layer by forming a number of n-1 conductive paths in a material of the semiconductor layer for connecting the n semiconductor devices.

According to a further embodiment, a semiconductor device module obtainable by a method of manufacturing a semiconductor device module including a number of n semiconductor devices, n being an integer ≥ 2, is provided, the method including: providing a substrate coated with a first contact layer, depositing a semiconductor layer on the first contact layer, depositing a second contact layer on the semiconductor layer, and thereafter connecting the first contact layer and the second contact layer by forming a number of n-1 conductive paths in the semiconductor layer for connecting the n semiconductor devices.

In another embodiment, a semiconductor device module obtainable by a method of manufacturing a semiconductor device module including a number of n semiconductor devices, n being an integer ≥ 2, is provided, the method including: providing a substrate coated with a first contact layer, depositing a semiconductor layer on the first contact layer, depositing a second contact layer on the semiconductor layer, and thereafter connecting the first contact layer and the second contact layer by forming a number of n-1 conductive paths in the semiconductor layer for connecting the n semiconductor devices, wherein the conductive paths are formed by laser treatment.

A yet further embodiment provides a semiconductor device module obtainable by a method of manufacturing a semiconductor device module including a number of n semiconductor devices, n being an integer ≥ 2, the method including: providing a substrate coated with a first contact layer, depositing a semiconductor layer on the first contact layer, depositing a second contact layer on the semiconductor layer, and thereafter connecting the first contact layer and the second contact layer by forming a number of n-1 conductive paths in the semiconductor layer for connecting the n semiconductor devices, wherein the semiconductor devices are at least one element chosen from solar cells, thin-film solar cells, thin-film solar cells of a substrate type, and thin-film solar cells of a superstrate type.

In another embodiment, a semiconductor device module obtainable by a method of manufacturing a semiconductor device module including a number of n semiconductor devices, n being an integer ≥ 2, is provided, the method including: providing a substrate coated with a first contact layer, having a semiconductor layer formed on the first contact layer, and having a second contact layer formed on the semiconductor layer; and connecting the first contact layer and the second contact layer by forming a number of n-1 conductive paths in the semiconductor layer for connecting the n semiconductor devices.

The written description uses examples to disclose the invention, including the best mode, and also to enable any person skilled in the art to make and use the invention. While the invention has been described in terms of various specific embodiments, those skilled in the art will recognize that the invention can be practiced with modifications within the spirit and scope of the claims. Especially, mutually non-exclusive features of the examples of embodiments and embodiments or modifications thereof described above may be combined with each other. The patentable scope of the invention is defined by the claims, and may include other examples that occur to those skilled in the art. Such other examples are intended to be within the scope of the claims.

While the foregoing is directed to embodiments of the invention, other and further embodiments of the invention may be devised without departing from the basic scope thereof, and the scope thereof is determined by the claims that follow.

## Claims

1. A method of manufacturing a semiconductor device module including a number of n semiconductor devices, n being an integer ≥ 2, the method comprising
a step of providing a substrate (10) coated with a first contact layer (20), and at least one step chosen from forming a semiconductor layer (30) on the first contact layer and forming a second contact layer (40) on the semiconductor layer; wherein the method comprises a step of forming a connection of the first contact layer and the second contact layer by forming a number of n-1 conductive paths (50) in a material of the semiconductor layer for connecting the n semiconductor devices.

2. The method according to claim 1, wherein the conductive paths are formed by laser treatment, and/or
wherein the conductive paths are formed by at least one process chosen from melting at least one of the layers, mixing at least one of the layers, reacting components of at least one of the layers, activating at least one component of at least one of the layers, diffusing components of at least one of the layers, and partially removing at least one of the layers, the layers being at least one layer chosen from the first contact layer, the semiconductor layer and the second contact layer.

3. The method according to any of the preceding claims, wherein the step of forming the connection of the first contact layer and the second contact layer is performed at a time chosen from: after forming the second contact layer, and before forming the second contact layer.

4. The method according to any of the preceding claims, wherein the first contact layer comprises at least a TCO, the second contact layer comprises at least one material chosen from a TCO and a metal, and/or the semiconductor layer comprises at least one material chosen from Si, a-Si, µc-Si, CdTe, GaAs and CuInSe, and/or
wherein the semiconductor devices are at least one element chosen from solar cells, thin-film solar cells, thin-film solar cells of a substrate type, and thin-film solar cells of a superstrate type, and/or
wherein the substrate is a transparent substrate, the substrate is a glass substrate, the semiconductor layer is an active layer of a solar cell, the first contact layer is a front contact layer, and/or the second contact layer is a back contact layer.

5. The method according to any of the preceding claims, comprising at least one step chosen from:
forming the first contact layer on the substrate (10);
forming a number of n-1 first grooves in the first contact layer after the step of forming the first contact layer, filling the first grooves with the semiconductor layer;
forming a number of n-1 second grooves in the second contact layer; and
forming a number of n-1 second grooves in the second contact layer and/or the semiconductor layer for separating neighboring semiconductor devices.

6. The method according to claim 5, wherein the step of forming the number of n-1 second grooves is performed after or before the step of forming the connection of the first contact layer and the second contact layer, and/or wherein at least two steps chosen from forming the connection of the first contact layer and the second contact layer, forming the first grooves, forming the second grooves in the second contact layer, and forming the second grooves in the second contact layer and/or the semiconductor layer are performed simultaneously.

7. The method according to any of the preceding claims, wherein at least one step chosen from forming the first grooves, forming the connection of the first contact layer and the second contact layer, forming the second grooves in the second contact layer, and forming the second grooves in the second contact layer and/or the semiconductor layer is performed by laser treatment.

8. The method according to claim 2 or 7, wherein at least one laser treatment is performed from at least one side chosen from a side of the first contact and a side of the second contact.

9. The method according to any of the preceding claims, wherein at least one element chosen from the conductive paths, the first grooves and the second grooves are formed in parallel to each other, and/or wherein at least one layer selected from the first contact layer and the second contact layer includes a transparent conductive oxide.

10. A semiconductor device connecting device for manufacturing a semiconductor device module,
the semiconductor device module comprising a number of n semiconductor devices and including a substrate (10) coated with a first contact layer (20), a semiconductor layer (30) on the first contact layer, and a second contact layer (40) on the semiconductor layer, and a number of n-1 conductive paths (50) in a material of the semiconductor layer for connecting the n semiconductor devices, n being an integer ≥ 2;
the semiconductor device connecting device comprising a first contact and second contact connection device (64) adapted to perform a step of forming a connection of the first contact layer and the second contact layer by forming a number of n-1 conductive paths in the material of the semiconductor layer for connecting the n semiconductor devices.

11. The semiconductor device connecting device according to claim 10, wherein the first contact and second contact connection device is adapted to additionally perform at least one step chosen from forming first grooves in the first contact layer, forming the second grooves in the second contact layer, and forming second grooves in the second contact layer and/or the semiconductor layer.

12. The semiconductor device connecting device according to claim 10 or 11, wherein the first contact and second contact connection device includes at least one laser device adapted to successively or simultaneously perform at least one step chosen from forming the first grooves, forming the connection of the first contact layer and the second contact layer, forming the second grooves in the second contact layer, and forming the second grooves in the second contact layer and/or the semiconductor layer.

13. The semiconductor device connecting device according to any of claims 10 to 12, wherein the semiconductor devices are at least one element chosen from solar cells, thin-film solar cells, thin-film solar cells of a substrate type, and thin-film solar cells of a superstrate type,
and/or wherein the substrate is a transparent substrate, the substrate is a glass substrate, the semiconductor layer is an active layer of a solar cell, the first contact layer is a front contact layer, and/or the second contact layer is a back contact layer.

14. A semiconductor device module manufacturing device for manufacturing a semiconductor device module, comprising a semiconductor device connecting device according to any of claims 10 to 13.

15. A semiconductor device module obtainable by a method according to any of claims 1 to 9.

## Amended claims

### Amended claims in accordance with Rule 137(2) EPC.

**1.** A method of manufacturing a semiconductor device module including a number of n semiconductor devices, n being an integer ≥ 2, the method comprising
a step of providing a substrate (10) coated with a first contact layer (20), and at least one step chosen from forming a semiconductor layer (30) on the first contact layer and forming a second contact layer (40) on the semiconductor layer; wherein the method comprises a step of forming a connection of the first contact layer and the second contact layer by forming a number of n-1 conductive paths (50) in a material of the semiconductor layer for connecting the n semiconductor devices,
wherein the conductive paths (50) are formed by at least one process chosen from melting at least one of the layers, mixing at least one of the layers, reacting components of the semiconductor layer (30) and at least one of the adjacent layers (20, 40), activating at least one component of the semiconductor layer (30) and of at least one of the adjacent layers (20, 40), diffusing components of at least one of the layers, and partially removing at least one of the layers, the layers being at least one layer chosen from the first contact layer (20), the semiconductor layer (30) and the second contact layer (40).

**2.** The method according to claim 1, wherein the conductive paths are formed by laser treatment, and/or
wherein the conductive paths are formed by partially removing at least one of the layers, the layers being at least one layer chosen from the first contact layer, the semiconductor layer and the second contact layer.

**3.** The method according to any of the preceding claims, wherein the step of forming the connection of the first contact layer and the second contact layer is performed at a time chosen from: after forming the second contact layer, and before forming the second contact layer.

**4.** The method according to any of the preceding claims, wherein the first contact layer comprises at least a TCO, the second contact layer comprises at least one material chosen from a TCO and a metal, and/or the semiconductor layer comprises at least one material chosen from Si, a-Si, µc-Si, CdTe, GaAs and CuInSe, and/or
wherein the semiconductor devices are at least one element chosen from solar cells, thin-film solar cells, thin-film solar cells of a substrate type, and thin-film solar cells of a superstrate type, and/or
wherein the substrate is a transparent substrate, the substrate is a glass substrate, the semiconductor layer is an active layer of a solar cell, the first contact layer is a front contact layer, and/or the second contact layer is a back contact layer.

**5.** The method according to any of the preceding claims, comprising at least one step chosen from:
forming the first contact layer on the substrate (10);
forming a number of n-1 first grooves in the first contact layer after the step of forming the first contact layer, filling the first grooves with the semiconductor layer;
forming a number of n-1 second grooves in the second contact layer; and
forming a number of n-1 second grooves in the second contact layer and/or the semiconductor layer for separating neighboring semiconductor devices.

**6.** The method according to claim 5, wherein the step of forming the number of n-1 second grooves is performed after or before the step of forming the connection of the first contact layer and the second contact layer, and/or wherein at least two steps chosen from forming the connection of the first contact layer and the second contact layer, forming the first grooves, forming the second grooves in the second contact layer, and forming the second grooves in the second contact layer and/or the semiconductor layer are performed simultaneously.

**7.** The method according to any of the preceding claims, wherein at least one step chosen from forming the first grooves, forming the connection of the first contact layer and the second contact layer, forming the second grooves in the second contact layer, and forming the second grooves in the second contact layer and/or the semiconductor layer is performed by laser treatment.

**8.** The method according to claim 2 or 7, wherein at least one laser treatment is performed from at least one side chosen from a side of the first contact and a side of the second contact.

**9.** The method according to any of the preceding claims, wherein at least one element chosen from the conductive paths, the first grooves and the second grooves are formed in parallel to each other, and/or wherein at least one layer selected from the first contact layer and the second contact layer includes a transparent conductive oxide.

**10.** A semiconductor device connecting device for manufacturing a semiconductor device module,
the semiconductor device module comprising a number of n semiconductor devices and including a substrate (10) coated with a first contact layer (20), a semiconductor layer (30) on the first contact layer, and a second contact layer (40) on the semiconductor layer, and a number of n-1 conductive paths (50) in a material of the semiconductor layer for connecting the n semiconductor devices, n being an integer ≥ 2;
the semiconductor device connecting device comprising a first contact and second contact connection device (64) adapted to perform a step of forming a connection of the first contact layer and the second contact layer by forming a number of n-1 conductive paths in the material of the semiconductor layer for connecting the n semiconductor devices, wherein the connection device (64) is adapted to form the conductive paths by at least one process chosen from melting at least one of the layers, mixing at least one of the layers, reacting components of the semiconductor layer (30) and at least one of the adjacent layers (20, 40), activating at least one component of the semiconductor layer (30) and of at least one of the adjacent layers (20, 40), diffusing components of at least one of the layers, and partially removing at least one of the layers, the layers being at least one layer chosen from the first contact layer (20), the semiconductor layer (30) and the second contact layer (40).

**11.** The semiconductor device connecting device according to claim 10,
wherein the first contact and second contact connection device is adapted to additionally perform at least one step chosen from forming first grooves in the first contact layer, forming the second grooves in the second contact layer, and forming second grooves in the second contact layer and/or the semiconductor layer.

**12.** The semiconductor device connecting device according to claim 10 or 11, wherein the first contact and second contact connection device includes at least one laser device adapted to successively or simultaneously perform at least one step chosen from forming the first grooves, forming the connection of the first contact layer and the second contact layer, forming the second grooves in the second contact layer, and forming the second grooves in the second contact layer and/or the semiconductor layer.

**13.** The semiconductor device connecting device according to any of claims 10 to 12, wherein the semiconductor devices are at least one element chosen from solar cells, thin-film solar cells, thin-film solar cells of a substrate type, and thin-film solar cells of a superstrate type,
and/or wherein the substrate is a transparent substrate, the substrate is a glass substrate, the semiconductor layer is an active layer of a solar cell, the first contact layer is a front contact layer, and/or the second contact layer is a back contact layer.

**14.** A semiconductor device module manufacturing device for manufacturing a semiconductor device module, comprising a semiconductor device connecting device according to any of claims 10 to 13.

**15.** A semiconductor device module obtainable by a method according to any of claims 1 to 9.
